# EUROPÄISCHE PATENTSCHRIFT

(11) **EP 3 935 927 B1**
(45) Veröffentlichungstag und Bekanntmachung des Hinweises auf die Patenterteilung: **25.01.2023**
(21) Anmeldenummer: 20709142.2
(22) Anmeldetag: 27.02.2020
(51) Int. Cl.: H05K 7/20

(54) **ELEKTRONISCHER KONVERTER AUSGEBILDET BASIEREND AUF SCHWEISSTECHNOLOGIEN**
ELECTRONIC CONVERTER DESIGNED ON THE BASIS OF WELDING TECHNOLOGIES
CONVERTISSEUR ÉLECTRONIQUE DONT LA CONCEPTION EST FONDÉE SUR DES TECHNOLOGIES DE SOUDAGE

(30) Priorität: 04.03.2019 DE 102019202903
(43) Veröffentlichungstag der Anmeldung: 12.01.2022
(73) Patentinhaber: Audi AG, 85045 Ingolstadt (DE); Hitachi Energy Switzerland AG, 5400 Baden (CH)
(72) Erfinder: GRADINGER, Thomas, 5032 Aarau Rohr (CH); BAUMANN, David, 5503 Schafisheim (CH); LIU, Chunlei, 5452 Oberrohrdorf (CH); TORRESIN, Daniele, 5400 Baden (CH)
(86) Internationale Anmeldenummer: PCT/EP2020/055141
(87) Internationale Veröffentlichungsnummer: WO 2020/178133

(56) Entgegenhaltungen:
- EP-A1- 3 276 657
- US-A1- 2001 017 763

## Beschreibung

Die vorliegende Erfindung betrifft einen Stromrichter umfassend ein Halbleitermodul und ein Kühlgehäuse, wobei das Halbleitermodul einen Halbleiterchip, ein Substrat mit einer ersten und einer zweiten Seite, eine Grundplatte mit einer ersten und einer zweiten Seite und eine Formmasse umfasst.

Im Stand der Technik ist es bekannt, ein mit Harz ummanteltes Modul in eine gemeinsame Grundplatte oder einen gemeinsamen Kühler zu löten.

Aus dem Dokument US 6,594,149 B2 ist eine flüssigkeitsgekühlte Schaltungsvorrichtung bekannt, mit einem Modul mit einem Schaltungselement und einer Modulbasisplatte, auf deren Oberfläche das Schaltungselement montiert ist, ein Schaltungsgehäuse zur Unterbringung des Moduls und eine Kühlflüssigkeitskammer zum Fließen einer Kühlflüssigkeit in Kontakt mit einer Rückseite der Modulbasisplatte des Moduls. Die Modulbasisplatte des Moduls ist in eine Öffnung eingepasst, die in einem die Kühlflüssigkeitskammer bildenden Element vorgesehen ist, und ohne Spalt verschweißt ist.

Aus dem Dokument US 6,473,303 B2 ist eine Kühlvorrichtung für ein Hochleistungs-Halbleitermodul bekannt, die ein Kühlerunterteil und ein Kühleroberteil aufweist, wobei das Kühleroberteil über eine stoffschlüssige Verbindung mit dem Kühlerunterteil verbunden ist. Das Kühleroberteil weist dabei eine Kühlplatte aus Metallmatrix-Verbundwerkstoff auf, an der mindestens ein Halbleiterbauteil angebracht werden kann. An der Kühlplatte ist ein Metallrand angeformt, um eine stoffschlüssige Verbindung zwischen dem Kühleroberteil und dem Kühlerunterteil zu ermöglichen.

Aus dem Dokument DE 10 2006 009 978 B4 ist bekannt, ein Leistungshalbleitermodul mit mindestens einer Halbleitereinheit und mit einer Bodenplatte als Träger zu schaffen. Die jeweilige Halbleitereinheit besteht aus einem Substrat mit einer Oberseite und einer Unterseite. Auf der Oberseite des Substrats ist mindestens eine Halbleitereinheit vorgesehen. Die Bodenplatte besitzt ihrerseits eine Oberseite, auf welcher die jeweilige Halbleitereinheit mit ihrer Unterseite, also mit der Unterseite des jeweiligen Substrats der Halbleitereinheit aufgebracht ist. Weitere Beispiele sind aus den Veröffentlichungen US 2001/017763 A1 und EP 3 276 657 A1 vorbekannt.

Es ist Aufgabe der vorliegenden Erfindung, eine Vorrichtung bereitzustellen, die es ermöglicht, geformte und gesinterte kompakte Halbbrückenmodule in einer Sixpack-Konfiguration in einem geschlossenen Kühler unterzubringen. Diese Aufgabe wird durch einen Stromrichter mit den Merkmalen des Patentanspruchs 1 sowie durch ein Verfahren mit den Merkmalen des Patentanspruchs 6 gelöst. Vorteilhafte Weiterbildungen und Ausführungsformen sind Gegenstand der Beschreibung und der Beschreibung der Figuren.

Gegenstand der vorliegenden Erfindung ist ein Stromrichter umfassend zumindest ein Halbleitermodul und ein Kühlgehäuse, wobei das mindestens eine Halbleitermodul einen Halbleiterchip, ein Substrat mit einer ersten Seite und einer zweiten Seite, eine Grundplatte mit einer ersten Seite und einer zweiten Seite und eine Formmasse bzw. Vergussmasse (mold compound) umfasst, dadurch gekennzeichnet, dass die Grundplatte aus Aluminiumsiliziumcarbid AlSiC mit einer aluminiumreichen Zone auf dem zweiten Bereich ausgebildet ist.

Erfindungsgemäß ist der Halbleiterchip mit der ersten Seite des Substrats verbunden, wobei die zweite Seite des Substrats mit der ersten Seite der Grundplatte verbunden ist, wobei die zweite Seite der Grundplatte einen ersten Bereich und einen zweiten Bereich aufweist, wobei der erste Bereich eine Oberflächenerweiterung in Form einer Kühlstruktur, bspw. realisiert durch Kühlrippen und/oder Kühlpins, aufweist, wobei der erste Bereich mit der Oberflächenerweiterung in einem Betriebszustand in direktem Kontakt mit einer Kühlflüssigkeit, die durch die Kühlstruktur fließt, steht, wobei der zweite Bereich einen geschlossenen Pfad um den ersten Bereich ausbildet, wobei das Kühlgehäuse eine Platte umfassend zumindest ein Loch aufweist, wobei die Platte um das Loch herum mit dem zweiten Bereich der Grundplatte durch Verschweißen verbunden ist.

Die vorliegende Erfindung ermöglicht die Integration von drei Halbleitermodulen, insbesondere Einzelhalbbrückenmodulen, in eine gemeinsame Platte durch Schweißtechnologien und Anschweißen eines Deckels, um einen Kühlpfad bzw. eine Fluidwanne herzustellen. Der Schweißprozess beeinträchtigt nicht die Funktionalität der Halbleitermodule und ermöglicht es, einen dichten Behälter ohne die Nutzung eines O-Rings oder Schrauben zu erstellen. Dadurch kann eine kompakte Lösung mit hoher Zuverlässigkeit und hoher Temperaturbeständigkeit erzielt werden.

Das Substrat ist in der Regel gesintert. Das Substrat ist eingerichtet, eine Grundplatte aufzunehmen.

Die Grundplatte eines Halbleitermoduls ist eingerichtet und ausgebildet, mit einer Platte, insbesondere einer Metallplatte verschweißbar zu sein. In Weiterbildung weist die Platte eine Six-Pack Konfiguration mit drei (zusammengebauten) Halbbrückenmodulen insgesamt umfassend sechs Halbleiterschalter auf. Die Platte umfassend mindestens ein Halbleitermodul ist eingerichtet, durch einen Deckel verschließbar zu sein. Die Platte umfassend das mindestens eine Halbleitermodul und der Deckel sind eingerichtet, in zusammengeführtem Zustand einen Kühlpfad auszubilden. Der Kühlpfad ist eingerichtet, ein Kühlfluid zu führen. In der Regel umfasst ein erfindungsgemäßer Stromrichter drei Halbleitermodule, insbesondere Halbbrückenmodule.

Um die Grundplatte und die Platte zu verbinden, kann das Schweißen ein Laserschweißen sein. Dadurch werden Maximaltemperatur und termperaturbedingte mechanische Spannungen begrenzt. Um die Platte mit einem Deckel zu verbinden, kann das Schweißen ein Laserschweißen, Reibrührschweißen oder ein Lichtbogenschweißen, insbesondere ein CMT-Schweißen sein. CMT steht für Cold Metal Transfer und ist ein spezielles Lichtbogenschweißverfahren.

In der Regel weisen die Grundplatte und die Platte das gleiche Material auf, wobei die verwendbaren Schweißtechnologien unterschiedlich sein können. Optional können die Grundplatte und die Platte verschiedene Aluminiumlegierungen umfassen. Laserschweißen bietet den Vorteil, dass es drucklos und sehr schnell ist und keine hohe Schweißtemperatur aufweist. Laserschweißen ist besonders vorteilhaft für die Verbindung der Halbleitermodule mit der Platte.

Reibrührschweißen und CMT-Schweißen sind besonders vorteilhaft, um die Platte mit dem Deckel zu verbinden, da die Anforderungen an eine Maximaltemperatur und mechanische Beanspruchung niedriger sind als bei der Verbindung der Halbleitermodule mit der Platte.

Die Grundplatte weist in der Regel ein Material auf, das bei einer der ausgewählten Schweißtechnologien einsetzbar ist, um eine erforderliche Dichtigkeit für die Kühlflüssigkeit zu erzielen. Das Material sollte einen bestmöglichen Kompromiss zwischen thermischer Leistung, Zuverlässigkeit, Korrosionsbeständigkeit und Schweißbarkeit bieten.

In der Regel weist die Grundplatte eine Oberflächengestaltung auf, die für den galvanischen Korrosionsschutz keine Beschichtung benötigt (z. B. Nickel), wenn die Grundplatte in einem Kühlkreislauf angeordnet ist. Beispielsweise ist die Grundplatte als eine Kupfer/Aluminium-Platte ausgebildet. Dabei weist die Grundplatte einen aluminiumbeschichteten Bereich auf, der eingerichtet ist, mit einem Kühlmedium, insbesondere einem Kühlfluid, in Kontakt zu stehen bzw. zu treten. Eine aus Aluminium ausgebildete oder in den mit Kühlfluid in Kontakten tretenden Bereichen mit Aluminium beschichtete Grundplatte bietet den Vorteil, dass diese in der Regel keine Oberflächenveredelung bzw. keine weitere Beschichtung als Korrosionsschutz benötigt. Kupfer hingegen wird für einen Kontakt mit einem Kühlfluid in der Regel mit Nickel beschichtet. Alternativ ist die Grundplatte aus AlSiC gebildet, wobei die Grundplatte in den Schweißbereichen mit Aluminium angereicherte Bereiche aufweist.

Der Deckel umfasst zumindest eine Einlass- und Auslassöffnung zur Bildung eines Kühlpfads.

In einer Weiterbildung der Erfindung ist die Platte aus Aluminium oder einer Aluminium-basierten Legierung ausgebildet.

Erfindungsgemäß ist die Grundplatte aus AlSiC mit einer aluminiumreichen Zone auf dem zweiten Bereich ausgebildet ist, die die Anwendbarkeit erleichtert. Alternativ besteht die Grundplatte aus mit Aluminium beschichtetem Kupfer.

In einer Weiterbildung umfasst die zweite Seite der Grundplatte einen Rand und der zweite Bereich bildet einen Kopf bzw. einen Ansatz des Randes. Der Rand bietet den Vorteil, dass der Abstand zwischen einer Schweißnaht bzw. zumindest einem Schweißpunkt der Schweißnaht und einem Halbleiterchip erhöht wird. Ein größerer Abstand zwischen einer Schweißnaht und einem Halbleiterchip bietet eine größere Flexibilität in der Auswahl der Schweißtechnologie. Eine Schweißtechnologie kann ein Laserschweißen oder ein Reibrührschweißen sein, auch in einer überlagernden bzw. kombinierten Ausführung. Ein Laserstrahl- oder ein Reibrührschweißgerät muss die Plattendicke durchdringen, um die Verbindungsstelle zwischen Platte und Grundplatte zu erreichen. Alternativ kann als Schweißtechnologie ein Lichtbogenschweißen, insbesondere ein CMT-Schweißen eingesetzt werden, indem ein Verbindungsmaterial auf eine Verbindungsstelle zwischen Platte und Grundplatte aufgebracht wird.

In einer Weiterbildung ist der Rand als Schulter ausgebildet, wobei jeweils eine Schulter in jeweils einem zweiten Bereich der zweiten Seite der Grundplatte ausgebildet ist, wobei zumindest eine Schulter aluminiumbeschichtet ausgebildet sind. Das Material der Grundplatte ist in der Regel eingerichtet, schweißbar zu sein. Um der Entstehung von spröden intermetallischen Phasen vorzubeugen, ist das Material der Grundplatte an dem Schweißpunkt bzw. an jeweiligen Schweißpunkten Aluminium.

In Ausgestaltung sind der Halbleiterchip und das Substrat in einer Formmasse mittels Epoxidharz eingeschlossen.

Gegenstand der Erfindung ist auch ein Verfahren zur Herstellung eines voranstehend beschriebenen Stromrichters umfassend zumindest ein Halbleitermodul und ein Kühlgehäuse, wobei das mindestens eine Halbleitermodul einen Halbleiterchip, ein Substrat mit einer ersten Seite und einer zweiten Seite, eine Grundplatte mit einer ersten Seite und einer zweiten Seite und eine Formmasse umfasst.

Erfindungsgemäß wird in einem ersten Schritt das zumindest eine Halbleitermodul in eine Platte eingebracht. Ein Halbleitermodul ist ein Einzelhalbbrückenmodul. In der Regel werden drei Halbleitermodule in eine gemeinsame Platte eingebracht.

In einem weiteren Schritt wird die zweite Seite der Grundplatte des zumindest einen Halbleitermoduls mit der Platte verschweißt. In der Regel werden drei umspritzte Halbleitermodule mit gesinterten Substraten auf eine gemeinsame Platte, insbesondere eine Aluminiumplatte, geschweißt. Das Verschweißen wird dabei von der Seite des Kühlmediums, der zweiten Seite der Grundplatte, aus durchgeführt, da die erste Seite der Grundplatte aufgrund der Formmasse nicht zugänglich ist.

In einem weiteren Schritt wird ein Deckel auf die Platte aufgebracht. Der Deckel wird mit der Platte verschweißt.

Anschließend wird der Deckel mit der Platte verschweißt und ein Kühlpfad ausgebildet. Der Kühlpfad wird durch zumindest eine Einlass- und Auslassöffnung mit einem Kühlfluid durchströmt.

Die Erfindung ist anhand von Ausführungsformen in der Zeichnung schematisch dargestellt und wird unter Bezugnahme auf die Zeichnung weiter beschrieben, wobei gleiche Komponenten mit gleichen Bezugsziffern gekennzeichnet sind. Es zeigt:
- Fig. 1a: eine perspektivische Ansicht einer Ausführungsform eines erfindungsgemäßen Halbleitermoduls, ausgestaltet als Einzelhalbbrückenmodul,
- Fig. 1b: eine perspektivische Ansicht einer Platte eines Kühlgehäuses einer Ausführungsform des erfindungsgemäßen Stromrichters,
- Fig. 2a: eine Draufsicht auf drei auf einer gemeinsamen Platte verschweißte Einzelhalbbrückenmodule,
- Fig. 2b: eine Schnittansicht der in Fig. 2a gezeigten Anordnung dreier auf einer gemeinsamen Platte verschweißten Einzelbrückenmodule,
- Fig. 3a: eine Ausführungsform eines erfindungsgemäßen Einzelhalbbrückenmoduls mit Schultergrundplatte,
- Fig. 3b: eine Draufsicht auf eine erfindungsgemäße Anordnung einer Verschweißung von drei Einzelhalbbrückenmodulen mit Schultergrundplatte auf einer gemeinsamen Platte,
- Fig. 3c: eine Querschnittsansicht auf die - in Fig. 3b - gezeigte Anordnung der drei Einzelhalbbrückenmodulen auf der gemeinsamen Platte,
- Fig. 4a: einen Deckel des Kühlgehäuses einer Ausführungsform des erfindungsgemäßen Stromrichters mit einer Einlass- und einer Auslassöffnung zur Bildung eines Kühlpfads.
- Fig. 4b: den - in Fig. 4a gezeigten - Deckel zur Abdeckung der Platte umfassend die Einzelhalbbrückenmodule in auf die Platte aufgesetztem Zustand,
- Fig. 5a: eine Ausführungsform der Grundplatte des erfindungsgemäßen Stromrichters,
- Fig. 5b: eine weitere Ausführungsform der Grundplatte des erfindungsgemäßen Stromrichters,
- Fig. 5c: eine weitere Ausführungsform der Grundplatte des erfindungsgemäßen Stromrichters,
- Fig. 6: eine Ausführungsform eines Aufbau einer erfindungsgemäßen Grundplatte.

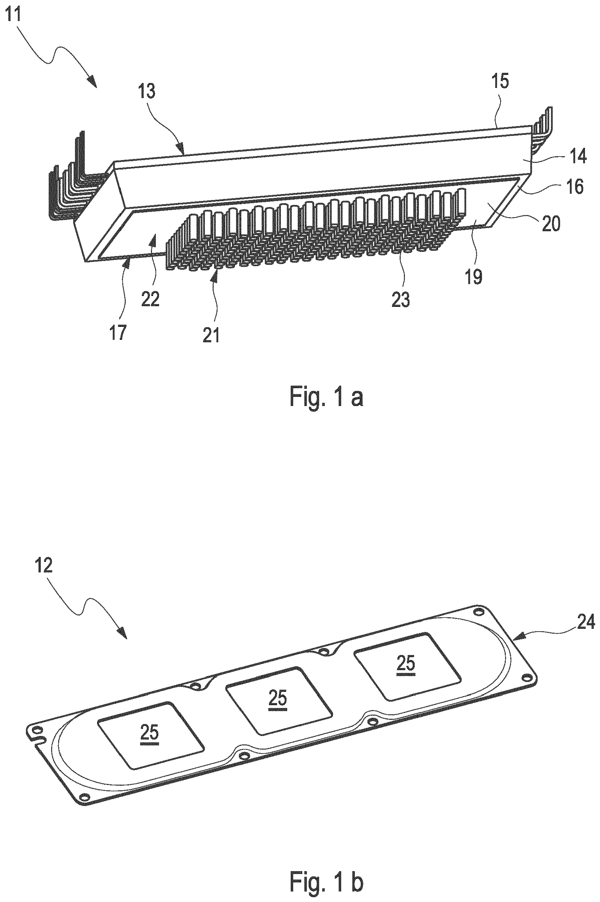

Figur 1a zeigt eine perspektivische Ansicht einer Ausführungsform eines erfindungsgemäßen Halbleitermoduls 11, ausgestaltet als Einzelhalbbrückenmodul. Das Halbleitermodul 11 umfasst einen Halbleiterchip 13, ein Substrat 14 mit einer ersten Seite 15 und einer zweiten Seite 16, eine Grundplatte 17 mit einer ersten Seite 18 (hier nicht erkennbar) und einer zweiten Seite 19 und eine Formmasse 20.

Der Halbleiterchip 13 ist mit der ersten Seite 15 des Substrats 14 verbunden ist, wobei die zweite Seite 16 des Substrats 14 mit der ersten Seite 18 der Grundplatte 17 verbunden ist.

Die zweite Seite 19 der Grundplatte 17 weist einen ersten Bereich 21 und einen zweiten Bereich 22 auf. Der erste Bereich 21 weist eine Oberflächenerweiterung 23 in Form von Kühlrippen 23 auf. Der erste Bereich 21 mit der Oberflächenerweiterung 23 steht in einem Betriebszustand in direktem Kontakt mit einer Kühlflüssigkeit, wobei der zweite Bereich 22 einen geschlossen Pfad in geschlossenem Zustand in einem Stromrichter um den ersten Bereich 21 ausbildet.

Figur 1b zeigt eine perspektivische Ansicht einer Platte 24 eines Kühlgehäuses 12 einer Ausführungsform des erfindungsgemäßen Stromrichters. Die Platte 24 weist drei Aussparungen 25 auf, die jeweils zur Aufnahme des in Fig. 1a gezeigten Halbleitermoduls 11 eingerichtet sind. Die Platte 24 ist aus Aluminium oder einer Aluminium-basierten Legierung ausgebildet, wobei die Platte 24, in einem mit den Halbleitermodulen 11 zusammengefügtem Zustand um die Aussparung 25 herum mit dem zweiten Bereich 22 der Grundplatte 17 durch Verschweißen verbunden ist.

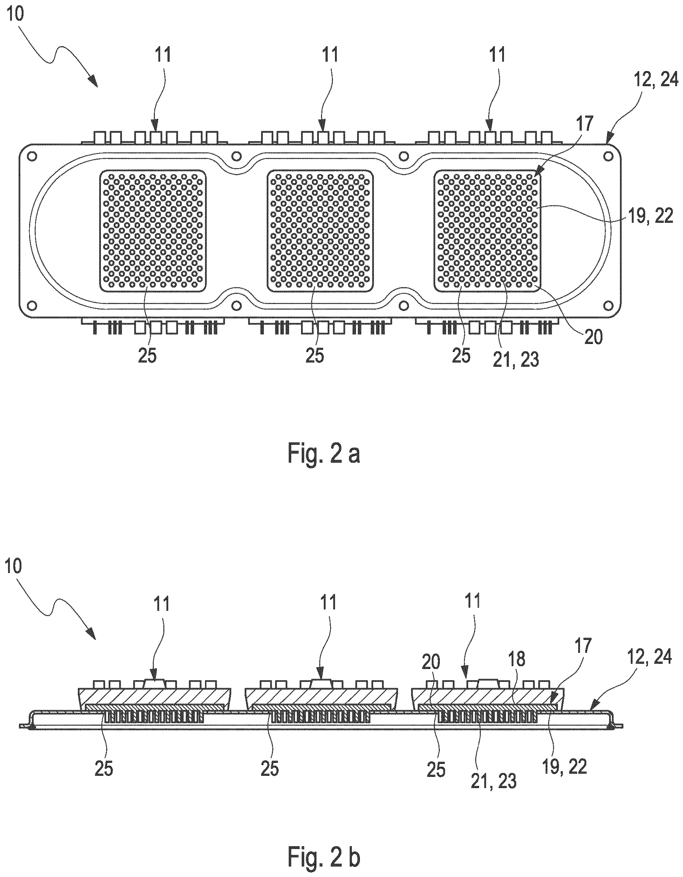

Figur 2a zeigt eine Draufsicht auf drei auf einer gemeinsamen Platte 24 verschweißte Einzelhalbbrückenmodule 11 eines Stromrichters 10. Dargestellt sind die drei Aussparungen 25 der Platte 24, in die die Einzelhalbbrückenmodule 11 aufgenommen sind. Die Einzelhalbbrückenmodule 11 sind mit der gemeinsamen Platte 24 verschweißt. Dadurch wird eine Sixpack-Anordnung basierend auf drei separaten Halbbrückenmodulen mit jeweils zwei Halbleiterschaltern mit spritzgepressten und gesinterten Substraten bereitgestellt.

Figur 2b zeigt eine Schnittansicht der - in Fig. 2a gezeigten - Anordnung dreier auf einer gemeinsamen Platte 24 verschweißten Einzelbrückenmodule 11. Dabei ragen die Kühlrippen 23 in die Aussparungen 25 der Platte 24 hinein.

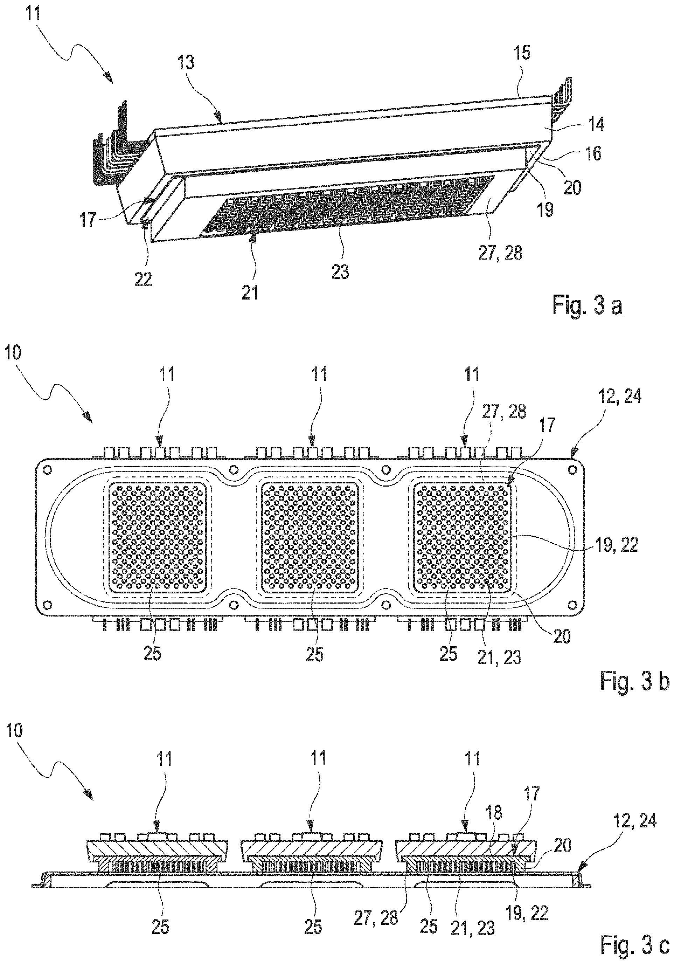

Figur 3a zeigt ein erfindungsgemäßes Einzelhalbbrückenmodul 11 mit einer Schultergrundplatte 27. Die Schultergrundplatte 27 ist auf der zweiten Seite 19 der Grundplatte 17 ausgebildet. Die Schultergrundplatte 27 weist einen Rand 28 auf. Der Rand ist an der zweiten Seite 19 der Grundplatte 17 ausgebildet und der zweite Bereich 22 der zweiten Seite 19 der Grundplatte 17 bildet einen Ansatz bzw. einen Kopf des Randes. In der vorliegenden Ausführungsform ist der Rand 28 als Schultern ausgebildet, die ausgehend von dem zweiten Bereich 22 in der gleichen Ausrichtung ausgebildet sind, wie die Kühlrippen 23. Die Schultern 28 sind um die Kühlrippen 23 umlaufend ausgebildet.

Figur 3b zeigt eine Draufsicht auf eine erfindungsgemäße Anordnung einer Verschweißung von drei - in Fig. 3a gezeigten - Einzelhalbbrückenmodulen 11 mit Schultergrundplatten 27 auf einer gemeinsamen Platte 24.

Figur 3c zeigt eine Querschnittsansicht auf die - in Fig. 3b - gezeigte Anordnung der drei Einzelhalbbrückenmodule 11 auf der gemeinsamen Platte 24. Dargestellt ist die Schultergrundplatte 27 mit den Schultern 28. Dargestellt ist ferner eine Schweißnaht entlang derer die drei Einzelhalbbrückenmodule 11 mit der Platte 24 verschweißt sind.

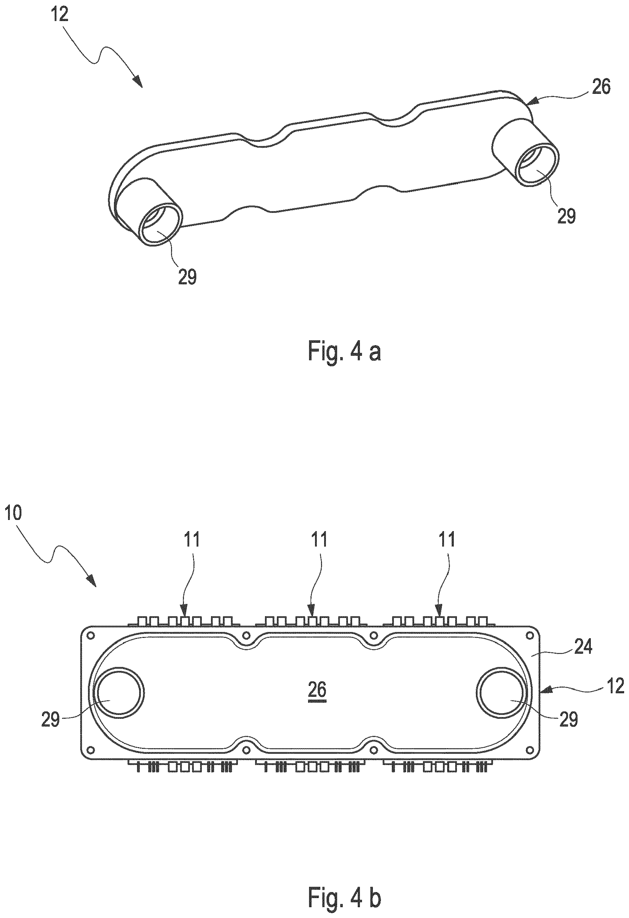

Figur 4a zeigt einen Deckel 26 des Kühlgehäuses 12 des erfindungsgemäßen Stromrichters mit zwei Einlass- und Auslassöffnungen 29. Mittels der Einlass- und Auslassöffnungen 29 wird bei verschlossenem Deckel 26 des Kühlgehäuses 12 ein Kühlpfad ausgebildet. Der Deckel 26 wird auf der Platte 24 mit den Einzelhalbrückenmodulen verschweißt.

Figur 4 b zeigt den - in Fig. 4a gezeigten - Deckel 26 zur Abdeckung der Platte 24 umfassend die Einzelhalbbrückenmodule11 in auf die Platte 24 aufgesetztem Zustand und verschweißtem Zustand.

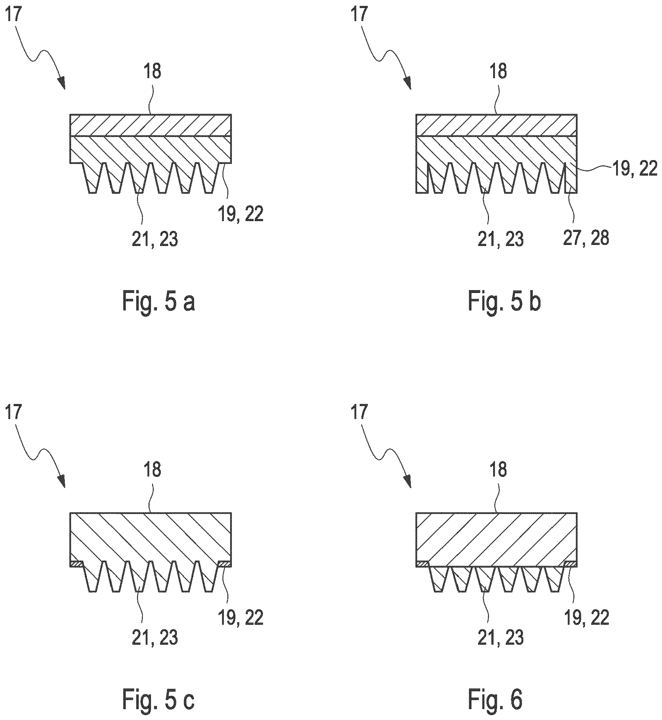

Figur 5a zeigt eine Ausführungsform der Grundplatte 17 des erfindungsgemäßen Stromrichters. Die Grundplatte 17 weist eine erste Seite 18 und eine zweite Seite 19 auf. Die zweite Seite 19 der Grundplatte 17 weist in einem ersten Bereich 21 eine quasi einstückig aus der zweiten Seite 19 hervorgehende Oberflächenerweiterung in Form von Kühlrippen 23 und einen zweiten den ersten Bereich 21 umgebenden Bereich 22 auf. Die erste Seite 18 der Grundplatte 17 ist aus Kupfer ausgebildet. Die zweite Seite 19 der Grundplatte 17 ist zusammen mit der Oberflächenerweiterung, d. h. hier den Kühlrippen 23 aus Aluminium ausgebildet. Die Grundplatte 17 kann demnach als mit Aluminium beschichtete Kupfer-Grundplatte mit Kühlrippen ausgestalten sein.

Figur 5b zeigt eine weitere Ausführungsform der Grundplatte 17 des erfindungsgemäßen Stromrichters. Die Grundplatte 17 weist eine erste Seite 18 und eine Seite 19 auf. Die zweite Seite 19 der Grundplatte 17 weist in einem ersten Bereich 21 eine aus der zweiten Seite 19 einstückig hervorgehende Oberflächenerweiterung mit einer Kühlstruktur, hier bspw. in Form von Kühlrippen 23 aus Aluminium, und in einem zweiten Bereich 22 eine Schultergrundplatte 27 mit Schultern 28 aus Aluminium auf. Die erste Seite 18 der Grundplatte 17 ist aus Kupfer ausgebildet. Die zweite Seite 19 der Grundplatte 17 ist zusammen mit der Kühlstruktur, hier den Kühlrippen 23, und den Schultern 28 aus Aluminium ausgebildet.

In der vorliegenden Ausführungsform ist die Schultergrundplatte 27 in die Grundplatte 17 direkt integriert. Die Schultergrundplatte 27 weist im zweiten Bereich 22 der Grundplatte 17 mit Aluminium beschichtete Schultern 28 auf. Somit kann eine Ausführungsform der Grundplatte 17 als eine mit Aluminium beschichtete Kupfer-Grundplatte mit Kühlrippen und Aluminiumbeschichteten Schultern 28 ausgebildet sein.

Figur 5c zeigt eine weitere Ausführungsform der Grundplatte 17 des erfindungsgemäßen Stromrichters. Die Grundplatte 17 weist eine erste Seite 18 und eine Seite 19 auf. Die zweite Seite 19 der Grundplatte 17 weist in einem ersten Bereich 21 eine in die Grundplatte integrierte bzw. aus der Grundplatte hervorgehende eine Kühlstruktur bildende Oberflächenerweiterung in Form von hier bspw. Kühlrippen 23 auf. Die Grundplatte 17 ist aus AlSiC (Aluminiumsiliziumcarbid) ausgebildet. Die in Fig. 5c dargestellte Ausführungsform weist mit Aluminium angereicherte Bereiche, durch enge Schraffur kenntlich gemacht, in einem zweiten Bereich 22 der zweiten Seite 19 an Schweißstellen auf. Durch die Ausgestaltung der Schweißstellen im zweiten Bereich 22 der zweiten Seite 19 der Grundplatte 17 aus Aluminium wird der Entstehung von spröden intermetallischen Phasen vorgebeugt.

Figur 6 zeigt eine Ausführungsform eines Aufbaus einer erfindungsgemäßen Grundplatte 17. Die Grundplatte 17 weist eine erste Seite 18 und eine zweite Seite 19 auf. Auf der zweiten Seite 19 ist in einem ersten Bereich 21 eine auf die zweite Seite 19 aufgebrachte bzw. auf der zweiten Seite 19 angeordnete Oberflächenerweiterung in Form von Kühlrippen 23 angeordnet. In einem zweiten Bereich 22 weist die zweite Seite 19 der Grundplatte 17 eine Aluminiumbeschichtung auf, wie durch enge Schraffur kenntlich gemacht.

### BEZUGSZEICHENLISTE:

- 10: Stromrichter
- 11: Halbleitermodul
- 12: Kühlgehäuse
- 13: Halbleiterchip
- 14: Substrat
- 15: erste Seite des Substrats
- 16: zweite Seite des Substrats
- 17: Grundplatte
- 18: erste Seite der Grundplatte
- 19: zweite Seite der Grundplatte
- 20: Formmasse
- 21: erster Bereich der zweiten Seite 19 der Grundplatte
- 22: zweiter Bereich der zweiten Seite 19 der Grundplatte
- 23: Kühlstruktur, Kühlrippen
- 24: Platte, Metallplatte
- 25: Aussparung
- 26: Deckel
- 27: Schultergrundplatte
- 28: Rand/Schultern
- 29: Einlass- und Auslassöffnung

## Patentansprüche

1. Stromrichter (10) umfassend zumindest ein Halbleitermodul (11) und ein Kühlgehäuse (12), wobei das mindestens eine Halbleitermodul (11) einen Halbleiterchip (13), ein Substrat (14) mit einer ersten Seite (15) und einer zweiten Seite (16), eine Grundplatte (17) mit einer ersten Seite (18) und einer zweiten Seite (19) und eine Formmasse (20) umfasst, wobei der Halbleiterchip (13) mit der ersten Seite (15) des Substrats (14) verbunden ist, wobei die zweite Seite (16) des Substrats (14) mit der ersten Seite (18) der Grundplatte (17) verbunden ist, wobei die zweite Seite (19) der Grundplatte (17) einen ersten Bereich (21) und einen zweiten Bereich (22) aufweist, wobei der erste Bereich (21) eine Oberflächenerweiterung (23) in Form einer Kühlstruktur (23) aufweist, wobei der erste Bereich (21) mit der Oberflächenerweiterung (23) in einem Betriebszustand in direktem Kontakt mit einer Kühlflüssigkeit steht, wobei der zweite Bereich (22) einen geschlossen Pfad um den ersten Bereich (21) ausbildet, wobei das Kühlgehäuse (12) eine Platte (24) umfassend zumindest eine Aussparung (25) aufweist, wobei die Platte (24) um die Aussparung (25) herum mit dem zweiten Bereich (22) der Grundplatte (17) durch Verschweißen verbunden ist, **dadurch gekennzeichnet, dass** die Grundplatte (17) aus Aluminiumsiliziumcarbid AlSiC mit einer aluminiumreichen Zone auf dem zweiten Bereich (22) ausgebildet ist.

2. Ein Stromrichter (10) nach Anspruch 1, **dadurch gekennzeichnet, dass** die Platte (24) aus Aluminium oder einer Aluminium-basierten Legierung ausgebildet ist.

3. Ein Stromrichter (10) nach Anspruch 1, **dadurch gekennzeichnet, dass** die zweite Seite (19) der Grundplatte (17) einen Rand (28) umfasst und der zweite Bereich (22) ein Ansatz des Rands (28) ist.

4. Ein Stromrichter nach Anspruch 3, **dadurch gekennzeichnet, dass** der Rand (28) als Schulter ausgebildet ist, wobei jeweils eine Schulter in jeweils einem zweiten Bereich (22) der zweiten Seite (19) der Grundplatte (17) ausgebildet ist, wobei zumindest eine Schulter aluminiumbeschichtet ausgebildet ist.

5. Ein Stromrichter (10) nach Anspruch 1, **dadurch gekennzeichnet, dass** der Halbleiterchip (11) und das Substrat (14) in einer Formmasse mittels Epoxidharz eingeschlossen sind.

6. Verfahren zur Herstellung eines Stromrichters (10) nach einem der Ansprüche 1 bis 5 umfassend zumindest ein Halbleitermodul (11) und ein Kühlgehäuse (12), wobei das mindestens eine Halbleitermodul (11) einen Halbleiterchip (13), ein Substrat (14) mit einer ersten Seite (15) und einer zweiten Seite (16), eine Grundplatte (17) mit einer ersten Seite (18) und einer zweiten Seite (19) und eine Formmasse (20) umfasst, wobei die Grundplatte (17) aus Aluminiumsiliziumcarbid AlSiC mit einer aluminiumreichen Zone auf dem zweiten Bereich (22) ausgebildet ist, umfassend die Schritte:
a) Einbringen des zumindest einen Halbleitermoduls in eine Platte,
b) Verschweißen der zweiten Seite der Grundplatte des zumindest einen Halbleitermoduls mit der Platte,
c) Aufbringung eines Deckels auf die Platte,
d) Verschweißen des Deckels mit der Platte und dadurch Ausbildung eines Kühlpfads.

## Claims

1. Converter (10) comprising: at least one semiconductor module (11) and a cooling housing (12), wherein the at least one semiconductor module (11) comprises a semiconductor chip (13), a substrate (14) having a first side (15) and a second side (16), a base plate (17) having a first side (18) and a second side (19), and a molding material (20), wherein the semiconductor chip (13) is connected to the first side (15) of the substrate (14), wherein the second side (16) of the substrate (14) is connected to the first side (18) of the base plate (17), wherein the second side (19) of the base plate (17) has a first region (21) and a second region (22), wherein the first region (21) has a surface extension (23) in the form of a cooling structure (23), wherein, in an operating state, the first region (21) with the surface extension (23) is in direct contact with a coolant liquid, wherein the second region (22) forms a closed path around the first region (21), wherein the cooling housing (12) has a plate (24) comprising at least one recess (25), wherein the plate (24) is connected around the recess (25) to the second region (22) of the base plate (17) by welding, **characterised in that** the base plate (17) is made of aluminum silicon carbide (AlSiC) having an aluminum-rich zone on the second region (22).

2. A converter (10) according to claim 1, **characterised in that**, the plate (24) is made of aluminium or an aluminium-based alloy.

3. A converter (10) according to claim 1, **characterised in that** the second side (19) of the base plate (17) comprises an edge (28) and the second region (22) is an attachment of the edge (28).

4. A converter according to claim 3, **characterised in that**, the edge (28) is configured as a shoulder, wherein in each case a shoulder is formed in a second region (22) of the second side (19) of the base plate (17), wherein at least one shoulder is aluminium coated.

5. A converter (10) according to claim 1, **characterised in that**, the semiconductor chip (11) and the substrate (14) are embedded in a moulding material by means of epoxy resin.

6. Method for producing a converter (10) according to any of claims 1 to 5 comprising at least one semiconductor module (11) and a cooling housing (12), wherein the at least one semiconductor module (11) comprises a semiconductor chip (13), a substrate (14) having a first side (15) and a second side (16), a base plate (17) having a first side (18) and a second side (19) and a moulding material (20), wherein the base plate (17) is made of aluminium silicon carbide AlSiC with an aluminium-rich zone on the section region (22) comprising the steps:
a) introducing the at least one semiconductor module into a plate,
b) welding the second side of the base plate of the at least one semiconductor module to the plate,
c) applying a cover to the plate,
d) welding the cover to the plate and thereby forming a cooling path.

## Revendications

1. Convertisseur (10) comprenant au moins un module semi-conducteur (11) et un boîtier de refroidissement (12), dans lequel l'au moins un module semi-conducteur (11) comprend une puce semi-conductrice (13), un substrat (14) avec un premier côté (15) et un second côté (16), une plaque de base (17) avec un premier côté (18) et un second côté (19) et un composé de moulage (20), dans lequel la puce semi-conductrice (13) est connectée au premier côté (15) du substrat (14), dans lequel le second côté (16) du substrat (14) est connecté au premier côté (18) de la plaque de base (17), dans lequel le second côté (19) de la plaque de base (17) présente une première zone (21) et une seconde zone (22), dans lequel la première zone (21) présente une extension de surface (23) sous forme d'une structure de refroidissement (23), dans lequel la première zone (21) avec l'extension de surface (23) est en contact direct avec un liquide de refroidissement dans un état de fonctionnement, dans lequel la seconde zone (22) forme un chemin fermé autour de la première zone (21), dans lequel le boîtier de refroidissement (12) présente une plaque (24) comprenant au moins un évidement (25), dans lequel la plaque (24) est connectée par soudage autour de l'évidement (25) à la seconde zone (22) de la plaque de base (17), **caractérisé en ce que** la plaque de base (17) est formée de carbure d'aluminium-silicium AlSiC avec une zone riche en aluminium sur la seconde zone (22).

2. Convertisseur (10) selon la revendication 1, **caractérisé en ce que** la plaque (24) est formée d'aluminium ou d'un alliage à base d'aluminium.

3. Convertisseur (10) selon la revendication 1, **caractérisé en ce que** le second côté (19) de la plaque de base (17) comprend un bord (28) et la seconde zone (22) est une extension du bord (28).

4. Un convertisseur selon la revendication 3, **caractérisé en ce que** le bord (28) est formé en tant qu'épaulement, dans lequel un épaulement est formé respectivement dans une seconde zone (22) du second côté (19) de la plaque de base (17), dans lequel au moins un épaulement est formé avec un revêtement en aluminium.

5. Convertisseur (10) selon la revendication 1, **caractérisé en ce que** la puce semi-conductrice (11) et le substrat (14) sont enfermés dans un composé de moulage au moyen de résine époxy.

6. Procédé de fabrication d'un convertisseur (10) selon l'une quelconque des revendications 1 à 5, comprenant au moins un module semi-conducteur (11) et un boîtier de refroidissement (12), dans lequel l'au moins un module semi-conducteur (11) comprend une puce semi-conductrice (13), un substrat (14) avec un premier côté (15) et un second côté (16), une plaque de base (17) avec un premier côté (18) et un second côté (19) et un composé de moulage (20), dans lequel la plaque de base (17) est formée de carbure d'aluminium-silicium AlSiC avec une zone riche en aluminium sur la seconde zone (22), comprenant les étapes consistant à :
a) insérer l'au moins un module semi-conducteur dans une plaque,
b) souder le second côté de la plaque de base de l'au moins un module semi-conducteur à la plaque,
c) appliquer un couvercle sur la plaque,
d) souder le couvercle à la plaque et ainsi former un chemin de refroidissement.
